(19) Europäisches Patentamt European Patent Office Office européen des brevets

(11) **EP 4 788 091 A1**

(12) **EUROPEAN PATENT APPLICATION**
published in accordance with Art. 153(4) EPC

(43) Date of publication:
**05.08.2026 Bulletin 2026/32**

(21) Application number: **25878442.0**

(22) Date of filing: **05.06.2025**

(51) International Patent Classification (IPC):
**H10F 19/90** *(2025.01)*

(52) Cooperative Patent Classification (CPC):
Y02E 10/50

(86) International application number:
**PCT/CN2025/099376**

(87) International publication number:
**WO 2026/123616 (18.06.2026 Gazette 2026/25)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.12.2024 CN 202411823605**

(71) Applicant: Zhejiang Aiko Solar Technology Co., Ltd
Jinhua, Zhejiang 322000 (CN)

(72) Inventors:
• XU, Zhigang
  Jinhua, Zhejiang 322000 (CN)
• YANG, Xinqiang
  Jinhua, Zhejiang 322000 (CN)
• WANG, Yongqian
  Jinhua, Zhejiang 322000 (CN)
• PENG, Qingqing
  Jinhua, Zhejiang 322000 (CN)

(74) Representative: EP&C
P.O. Box 3241
2280 GE Rijswijk (NL)

(54) **BACK-CONTACT SOLAR CELL MODULE AND PHOTOVOLTAIC SYSTEM**

(57)    The present disclosure is applicable to the field of photovoltaic technology, and provides a back contact solar cell assembly and a photovoltaic system. Composite solder ribbons and a plurality of back contact solar cells are included. The composite solder ribbons are arranged on backlight surfaces of the plurality of back contact solar cells. Each of the composite solder ribbon includes a first conductive layer and a second conductive layer, where the second conductive layer is arranged on an outer surface of the first conductive layer, the first conductive layer includes an aluminum element, and the second conductive layer includes a copper element or a nickel element. A mass ratio of the second conductive layer to the first conductive layer of each of the composite solder ribbons is composite solder ribbons component ratio C which is greater than or equal to 0.1. By controlling a yield strength of the composite solder ribbons within a preset range, the present disclosure can solve the problem of cell piece warping caused by easy warping of the composite solder ribbons, and compared to conventional copper solder ribbons, greatly reduces costs, thereby effectively reducing production costs of the cell assembly.

Fig. 1

## Description

## Cross-Reference to Related Application

The present disclosure claims priority to Chinese Patent Application No. 202411823605.0, filed on December 12, 2024, and entitled "Back contact solar cell assembly and photovoltaic system", which is incorporated herein by reference in its entirety.

## Technical Field

The present disclosure belongs to the field of photovoltaic technology, and in particular, to a back contact solar cell assembly and a photovoltaic system.

## Background

Solar energy is inexhaustible clean energy. With the development of the solar energy industry, the installed capacity of photovoltaics has been steadily increasing. With continuous technological innovation, the cost per kilowatt-hour has been declining, and the demand for grid parity has grown increasingly urgent. Consequently, how to reduce costs and improve efficiency have become top priorities for the industry. At a photovoltaic module end, conventional photovoltaic solder ribbons are typically manufactured using oxygen-free copper, resulting in high fabrication costs of the photovoltaic solder ribbons. With the ongoing update and iteration of current module and cell technologies, such as the emergence of tunnel oxide passivated contact (Topcon), heterojunctions, and interdigitated back contact (IBC), the demand for the solder ribbons is continuously evolving. Under the premise of satisfying conductivity, fabricating low-cost solder ribbons to replace conventional oxygen-free copper solder ribbons, while controlling costs of the solder ribbons at a low level and achieving both high quality and affordability, represents an urgent problem that needs to be solved.

Although the fabrication costs of current conventional composite solder ribbons are reduced, when soldering is performed at a certain soldering temperature, differences in thermal expansion coefficients of various metals can easily cause warping of the composite solder ribbons, which leads to forced deformation at contact parts between cell pieces and the composite solder ribbons, resulting in cell piece warping and cracking, and ultimately increasing the defect rate of cell assembly.

How to control the warping of the composite solder ribbons in back contact solar cell assembly has become crucial, which holds positive significance for breaking the inherent perception of the market on IBC cells as being high-efficiency yet high-cost, and allowing the IBC cells to gain access to a broader application market.

## Summary

In a first aspect, the present disclosure provides a back contact solar cell assembly, to solve the problem about how to control the warping of composite solder ribbons in the back contact solar cell assembly.

The present disclosure is implemented in this manner. A back contact solar cell assembly includes composite solder ribbons and a plurality of back contact solar cells. The composite solder ribbons are arranged on backlight surfaces of the plurality of back contact solar cells. Each of the composite solder ribbon includes a first conductive layer and a second conductive layer, the second conductive layer is arranged on an outer surface of the first conductive layer, the first conductive layer includes an aluminum element, and the second conductive layer includes a copper element or a nickel element. A mass ratio of the second conductive layer to the first conductive layer of each of the composite solder ribbons is a composite solder ribbon component ratio C which is greater than or equal to 0.1, each of the composite solder ribbons has a first connecting portion which is arranged between the two adjacent back contact solar cells, an included angle a between the first connecting portion and the backlight surface of the back contact solar cell is greater than or equal to 0° and less than or equal to 60°, and the included angle a and a yield strength $\sigma s$ of the composite solder ribbons satisfy the following relationship: $(90/1.63) \times \cos a \leq \sigma s \leq \cos a \times 90$, where a is greater than or equal to 0° and less than or equal to 60°.

In the present disclosure, the composite solder ribbons are arranged on the backlight surfaces of the plurality of back contact solar cells. Compared to a bifacial cell structure, the arrangement of the composite solder ribbons on a single side surface of the back contact solar cell significantly reduces a degree of bending required for the composite solder ribbons, making it possible to connect the plurality of back contact solar cells by the composite solder ribbons without warping within a set yield strength range. By controlling the yield strength of the composite solder ribbons within a preset range, the problem of cell piece warping caused by easy warping of the composite solder ribbons can be solved. The morphology, composition, and size of the composite solder ribbons can be diversely designed to meet process requirements of various types of solar cell assembly. Compared to conventional copper solder ribbons, the cost is greatly reduced, thereby effectively reducing the production cost of the cell assembly. Additionally, the included angle a between the first connecting portion of the composite solder ribbons and the backlight surface of the back contact solar cell and the yield strength $\sigma s$ of the composite solder ribbons satisfy the relationship: $(90/1.63) \times \cos a \leq \sigma s \leq \cos a \times 90$, where a is greater than or equal to 0° and less than or equal to 60°, the present disclosure further ensures good adhesion and stable welding without deformation between the composite solder ribbons and cell pieces when using the composite solder ribbons for serial soldering of the cell pieces. Especially in an overlapped area between the cell pieces, the composite solder ribbons can achieve smooth transition connections, avoiding phenomena such as cold soldering or desoldering in the overlapped area of the cell pieces.

In some embodiments, the plurality of back contact solar cells are arranged at intervals. The included angle a between the first connecting portion and the backlight surface of the back contact solar cell is greater than or equal to 0° and less than or equal to 20°.

In some embodiments, the included angle a between the first connecting portion and the backlight surface of the back contact solar cell is greater than or equal to 0° and less than or equal to 10°.

In some embodiments, the included angle a between the first connecting portion and the backlight surface of the back contact solar cell is greater than or equal to 0° and less than or equal to 5°.

In some embodiments, the plurality of back contact solar cells are partially overlapped. The included angle a between the first connecting portion and the backlight surface of the back contact solar cell is greater than or equal to 10° and less than or equal to 60°.

In some embodiments, the included angle a between the first connecting portion and the backlight surface of the back contact solar cell is greater than or equal to 10° and less than or equal to 45°.

In some embodiments, the composite solder ribbon component ratio C is greater than or equal to 0.2.

In some embodiments, the composite solder ribbon component ratio C ranges from 0.25 to 2.4.

In some embodiments, each of the composite solder ribbons further includes a composite structure layer. The first conductive layer and the second conductive layer are compounded to form the composite structure layer, which is arranged between the first conductive layer and the second conductive layer.

In some embodiments, a thickness of the composite structure layer is 0 to 30 micrometers.

In some embodiments, components of the composite structure layer include at least one of $Al_4Cu_9$, AlCu, $Al_2Cu$, $Al_2Cu_3$, $Al_3Cu_4$, or Cu.

In some embodiments, each of the composite solder ribbons further includes a conductive connecting layer arranged on a surface of the second conductive layer.

In some embodiments, a thickness of the conductive connecting layer is 1 to 20 micrometers.

In some embodiments, components of the conductive connecting layer include at least one of Sn, Bi, or Pb.

In some embodiments, based on a first preset temperature, the components of the conductive connecting layer include Sn, Bi, and Pb, where the Bi content is 10% to 40%, the Sn content is 20% to 50%, and the Pb content is 30% to 60%.

In some embodiments, based on a second preset temperature, the components of the conductive connecting layer include Sn and Pb, where the Sn content is 50% to 70%, and the Pb content is 30% to 50%.

In some embodiments, a resistance of the composite solder ribbon is greater than or equal to 60 milliohms and less than or equal to 150 milliohms.

In some embodiments, a connecting layer is further included, and arranged between the first conductive layer and the second conductive layer.

In some embodiments, the connecting layer includes zinc.

In some embodiments, the composite solder ribbon is a flat solder ribbon.

In some embodiments, when a thickness of the composite solder ribbon is 0.1 mm, a width of the composite solder ribbon is less than 2.5 mm; or, when the width of the composite solder ribbon is 2.5 mm, the thickness of the composite solder ribbon is greater than 0.1 mm.

In some embodiments, when the width of the composite solder ribbon is 0.4 mm to 0.8 mm and the thickness of the composite solder ribbon is 0.2 mm to 0.3 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa.

In some embodiments, when the width of the composite solder ribbon is 0.8 mm to 1.4 mm and the thickness of the composite solder ribbon is 0.12 mm to 0.2 mm: the composite solder ribbon component ratio C is 0.2 to 0.3, and the yield strength is 55 MPa to 65 MPa; or, the composite solder ribbon component ratio C is 0.3 to 0.8, and the yield strength is 60 MPa to 70 MPa; or, the composite solder ribbon component ratio C is 0.8 to 1.2, and the yield strength is 62 MPa to 72 MPa; or, the composite solder ribbon component ratio C is 1.2 to 2, and the yield strength is 65 MPa to 75 MPa; or, the composite solder ribbon component ratio C is 2 to 3, and the yield strength is 70 MPa to 80 MPa.

In some embodiments, when the width of the composite solder ribbon is 1.4 mm to 1.8 mm and the thickness of the composite solder ribbon is 0.1 mm to 0.15mm: the composite solder ribbon component ratio C is 0.2 to 0.3, and the yield strength is 55 MPa to 65 MPa; or, the composite solder ribbon component ratio C is 0.3 to 0.8, and the yield strength is 60 MPa to 70 MPa; or, the composite solder ribbon component ratio C is 0.8 to 1.2, and the yield strength is 62 MPa to 72 MPa; or, the composite solder ribbon component ratio C is 1.2 to 2, and the yield strength is 65 MPa to 75 MPa; or, the composite solder ribbon component ratio C is 2 to 3, and the yield strength is 70 MPa to 80 MPa.

In some embodiments, when the width of the composite solder ribbon is 1.8 mm to 2.2 mm and the thickness of the composite solder ribbon is 0.12 mm to 0.2 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa.

In some embodiments, when the width of the composite solder ribbon is 1.8 mm to 2.2 mm and the thickness of the composite solder ribbon is 0.05 mm to 0.12 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa.

In some embodiments, when the width of the composite solder ribbon is 2.2 mm to 2.8mm and the thickness of the composite solder ribbon is 0.12 mm to 0.2 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa.

In some embodiments, the composite solder ribbon is a round wire solder ribbon, with a diameter length greater than or equal to 0.07 mm and less than or equal to 0.4 mm.

In some embodiments, when the diameter length of the composite solder ribbon is 0.07 mm to 0.2 mm: the composite solder ribbon component ratio C is 0.2 to 0.3, and the yield strength is 65 MPa to 75 MPa; or, the composite solder ribbon component ratio C is 0.3 to 0.8, and the yield strength is 70 MPa to 80 MPa; or, the composite solder ribbon component ratio C is 0.8 to 1.2, and the yield strength is 72 MPa to 82 MPa; or, the composite solder ribbon component ratio C is 1.2 to 2, and the yield strength is 75 MPa to 85 MPa; or, the composite solder ribbon component ratio C is 2 to 3, and the yield strength is 80 MPa to 90 MPa.

In some embodiments, when the diameter length of the composite solder ribbon is 0.2 mm to 0.3 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa.

In some embodiments, when the diameter length of the composite solder ribbon is 0.3 mm to 0.4 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa.

In some embodiments, the composite solder ribbon is a triangular solder ribbon, with a diameter length of a circumscribed circle of the composite solder ribbon being greater than or equal to 0.07 mm and less than or equal to 0.4 mm.

In some embodiments, a ratio of a thickness of the first conductive layer to a thickness of the second conductive layer is greater than or equal to 5 and less than or equal to 9.

In some embodiments, the thickness of the second conductive layer is 0.01 mm to 0.05 mm.

In some embodiments, each of the composite solder ribbons includes a plurality of free portions and a plurality of second connecting portions connecting the plurality of free portions, and the second connecting portions are connected to the back contact solar cells, while the free portions are detached from the back contact solar cells.

In some embodiments, a maximum spacing distance between the free portions and the back contact solar cells ranges from 0.1 mm to 0.4 mm.

In a second aspect, a photovoltaic system includes the foregoing solar cell assembly.

## Brief Description of the Drawings

Fig. 1 is a schematic structural diagram of a first composite solder ribbon according to this application;

Fig. 2 is a schematic structural diagram of a second composite solder ribbon according to this application;

Fig. 3 is a schematic structural diagram of a third composite solder ribbon according to this application;

Fig. 4 is a schematic structural diagram of a fourth composite solder ribbon according to this application;

Fig. 5 is a schematic structural diagram of a fifth composite solder ribbon according to this application;

Fig. 6 is a schematic structural diagram of a sixth composite solder ribbon according to this application;

Fig. 7 is a schematic structural diagram of a seventh composite solder ribbon according to this application;

Fig. 8 is a schematic structural diagram of an eighth composite solder ribbon according to this application;

Fig. 9 is a schematic structural diagram of a first back contact solar cell assembly according to this application; and

Fig. 10 is a schematic structural diagram of a second back contact solar cell assembly according to this application.

Description of Reference Numerals:
100-composite solder ribbon; 101-first conductive layer; 102-second conductive layer; 103-first connecting portion; 104-composite structure layer; 105-conductive connecting layer; 106-free portion; 107-second connecting portion; 108-connecting layer; and 200-back contact solar cell.

**Detailed Description of the Embodiments**

In order to provide a clearer understanding of the objectives, technical solutions, and advantages of the present disclosure, the present disclosure is further described in detail in conjunction with accompanying drawings and embodiments below. Examples of the embodiments are shown in accompanying drawings, where the same or similar elements or the elements having the same or similar functions are denoted by the same or similar numerals throughout the description. The embodiments described below with reference to the accompanying drawings are exemplary, are used only for explaining the present disclosure, and should not be construed as a limitation on the present disclosure. Additionally, it should be understood that the specific embodiments described herein are merely used for explaining the present disclosure rather than limiting the present disclosure.

In the description of the present disclosure, it should be understood that orientation or position relationships indicated by the terms such as "length", "width", "upper", "lower", "left", "right", "horizontal", "top", and "bottom", are based on orientation or position relationships shown in the accompanying drawings, and are intended to facilitate the description of the present disclosure and simplify the description only, rather than indicate or imply that an apparatus or element referred needs to have a particular orientation or be constructed and operated in a particular orientation. Therefore, such terms should not be construed as limiting the present disclosure.

Additionally, the terms "first" and "second" are used merely for the purpose of description, and should not be construed as indicating or implying relative importance or implying a quantity of indicated technical features. Therefore, features defined as "first" and "second" may explicitly or implicitly include one or more of the features. In the descriptions of the present disclosure, unless otherwise explicitly limited, "a plurality of" means two or more than two.

In the description of the present disclosure, it should be noted that the terms "mounted", "connected", and "linked" should be understood in a broad sense, unless otherwise explicitly specified and limited. For example, it may be a fixed connection, a detachable connection, or an integrated connection; it may be a mechanical connection, an electrical connection, or a mutual communication; or it may be a direct connection, an indirect connection through an intermediate medium, a communication between interiors of two elements, or an interaction relationship between the two elements. Those of ordinary skill in the art may understand the specific meanings of the foregoing terms in the present disclosure according to specific situations.

In the present disclosure, unless otherwise expressly specified and limited, a first feature being "above" or "below" a second feature may include direct contact between the first feature and the second feature, or may also include indirect contact between the first feature and the second feature through an additional feature therebetween. In addition, the first feature being "over", "above", and "on" the second feature includes the first feature being over and above the second feature, or merely indicates that a level of the first feature is higher than that of the second feature. The first feature being "under", "below", and "underneath" the second feature includes the first feature being under and below the second feature, or merely indicates that the level of the first feature is lower than that of the second feature.

The following disclosure provides multiple different embodiments or examples to implement different structures of the present disclosure. To simplify the disclosure of the present disclosure, components and settings in particular examples are described below. Certainly, they are merely examples and are not intended to limit the present disclosure. Further, in the present disclosure, reference numerals and/or reference letters may be repeated in different examples, and such repetition is for simplification and clarity purposes and does not indicate a relationship between the various embodiments and/or settings being discussed. In addition, the present disclosure provides examples of various specific processes and materials, but those of ordinary skill in the art can realize the application of other processes and/or the use of other materials.

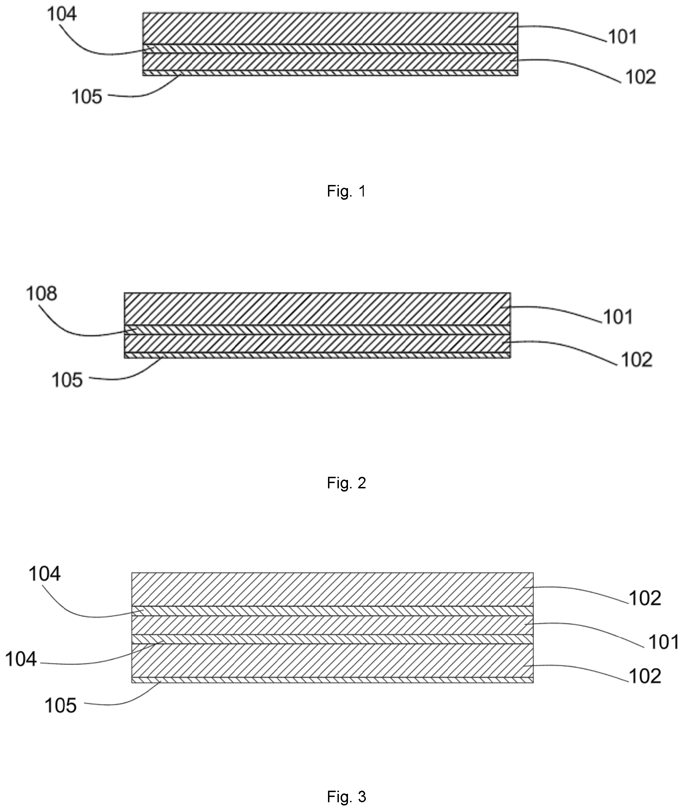

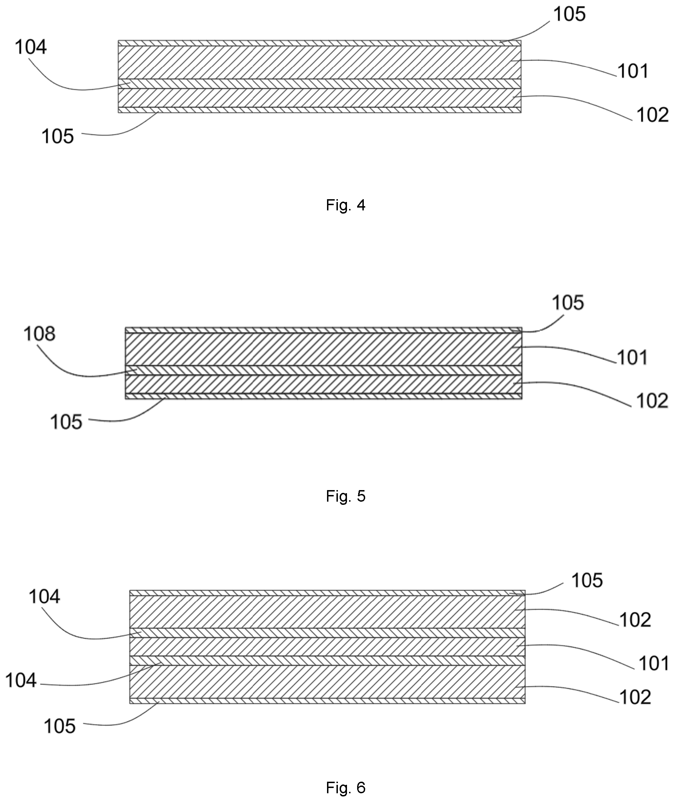

As shown in Figs. 1 to 10, in some embodiments, a back contact solar cell assembly includes composite solder ribbons 100 and a plurality of back contact solar cells 200. The composite solder ribbons 100 are arranged on backlight surfaces of the plurality of back contact solar cells 200. Compared to a bifacial cell structure, the arrangement of the composite solder ribbons 100 on a single side surface of the back contact solar cell 200 significantly reduces a degree of bending required for the composite solder ribbons 100, making it possible to connect the plurality of back contact solar cells 200 by the composite solder ribbons 100 within a set yield strength range. It should be noted that in this embodiment, a welding method is primarily used for electrical and physical connections between the back contact solar cells 200 and the composite solder ribbons 100. However, it should be understood that other methods may also be employed for connections, which may be set according to usage requirements, and no specific limitations are imposed herein.

The composite solder ribbon 100 includes a first conductive layer 101 and a second conductive layer 102. The second conductive layer 102 is arranged on an outer surface of the first conductive layer 101. The first conductive layer 101 includes an aluminum element, and the second conductive layer 102 includes a copper element or a nickel element. In this embodiment of the present disclosure, metallurgical bonding of bilayer conductive materials between the first conductive layer 101 and the second conductive layer 102 is achieved through electroplating, casting, forging, or cold rolling, with no limitations imposed by the present disclosure. In some embodiments, a material of the second conductive layer 102 includes one or more of nickel, tin, bismuth, silver, copper, aluminum, titanium, lead, indium, or gallium. That is, the material of the second conductive layer 102 may be a single material or a combination or alloy of a plurality of materials, as long as electric conduction can be achieved while welding is facilitated, and is not limited to the materials listed in this embodiment. In this embodiment of the present disclosure, copper is preferred for the material of the second conductive layer 102 due to its good ductility and excellent electrical conductivity. A material of the first conductive layer 101 may be a metal material such as aluminum, an aluminum alloy, zinc, or nickel. Considering functional requirements for electric conduction, aluminum is preferred for the first conductive layer 101 due to its soft texture, high stability, high corrosion resistance, low cost, and ease of subsequent deep processing and compounding.

The composite solder ribbon 100 has a corresponding yield strength based on a preset size and a corresponding composite solder ribbon component ratio C, where the composite solder ribbon component ratio C is a mass ratio of the second conductive layer 102 to the first conductive layer 101, and the composite solder ribbon component ratio C is greater than or equal to 0.1. In this embodiment of the present disclosure, corresponding yield strengths are set for composite solder ribbons 100 with different preset sizes and different composite solder ribbon component ratios C. By setting different yield strengths for different types of composite solder ribbons 100, the problem of warping that tends to occur after hot-press annealing of the composite solder ribbon 100 can be better controlled. Additionally, researchers have invested significant effort in research and testing, ultimately concluding that the yield strength is a key factor affecting warping of the composite solder ribbon 100. Based on this understanding, the researchers optimize an applicable range of yield strengths for different types of composite solder ribbons 100, ultimately successfully solving the problem of cell piece warping. While reducing costs, the applicability and ease of use of the composite solder ribbon 100 are ensured, facilitating popularization and application.

It should be understood that in the present disclosure, the mass ratio of the second conductive layer 102 to the first conductive layer 101 is set to be greater than or equal to 0.1. Further, the mass ratio of the second conductive layer 102 to the first conductive layer 101 is set to be greater than or equal to 0.2. In some implementations, the mass ratio of the second conductive layer 102 to the first conductive layer 101 ranges from 0.25 to 2.4. In such embodiments, the mass ratio of the second conductive layer 102 to the first conductive layer 101 may be 0.25, 0.26, 0.28, 0.3, 0.4, 0.6, 0.8, 1.2, 1.6, 1.8, 2.2, 2.4, or any value between 0.25 and 2.4, with no specific limitations imposed herein. Within the mass ratio range of the second conductive layer 102 to the first conductive layer 101, on one hand, the fabrication cost of the composite solder ribbon 100 can be effectively reduced. On the other hand, the bond strength between the first conductive layer 101 and the second conductive layer 102 in the composite solder ribbon 100 is an important consideration factor. Exemplarily, in a cold rolling composite process, when a thickness ratio of copper to aluminum decreases (i.e., a thickness of aluminum increases), an aluminum strip undergoes more severe plastic deformation, forming more cracks at an interface. These cracks facilitate the entry of more metal compounds and promote interface bonding, resulting in a stronger bond between a copper strip and the aluminum strip. When an aluminum layer is excessively thick, due to a difference in yield stress between copper and aluminum, the time required to achieve common plastic strain increases, potentially leading to poorer compactness at the bonding interface, which in turn affects the bond strength.

Within this range, the bond strength between the first conductive layer 101 and the second conductive layer 102 is high, and the formed composite solder ribbon 100 can resist external stress, preventing delamination or detachment between the two layers due to force.

Additionally, changes in the mass ratio of the second conductive layer 102 to the first conductive layer 101 may also affect the mechanical performance of the composite solder ribbon 100. For example, when the aluminum content is high, the composite ribbon may exhibit better toughness and ductility; whereas when the copper content is high, the conductivity, strength, and hardness of the composite ribbon may be improved. Within this mass ratio range of the second conductive layer 102 to the first conductive layer 101, the formed composite solder ribbon 100 has good ductility and high structural strength, and can achieve stable connections between cell pieces.

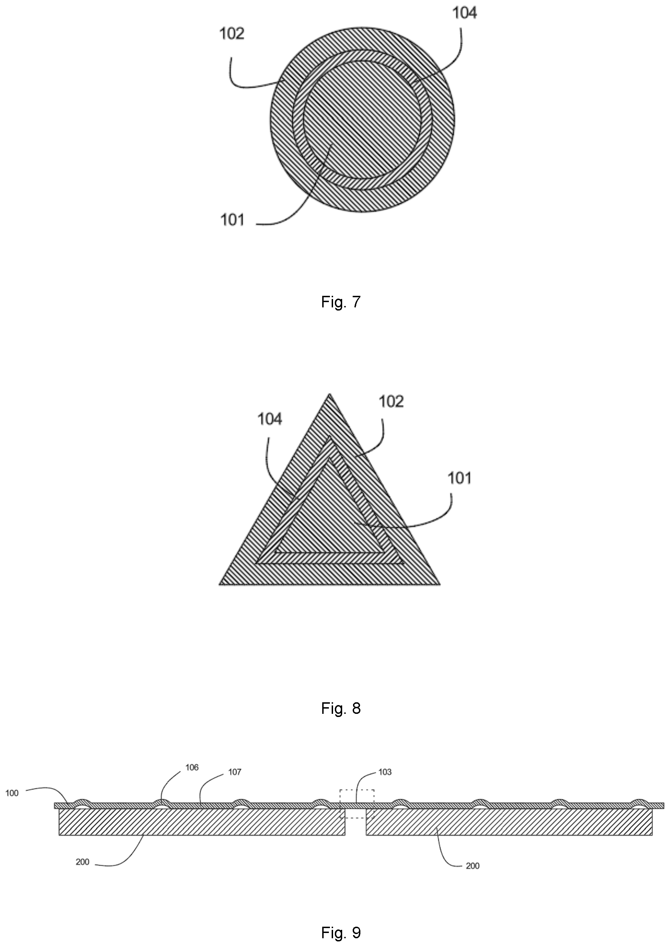

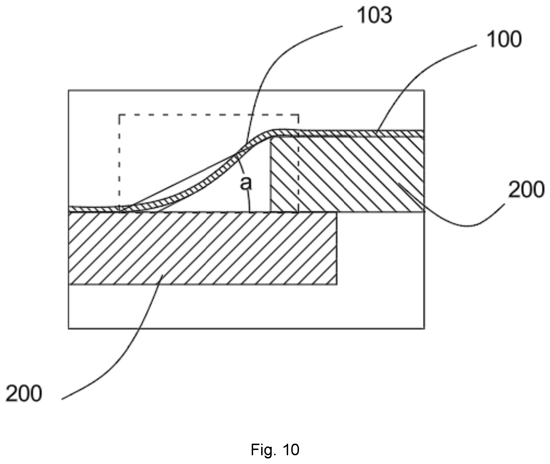

In some embodiments, as shown in Fig. 9 and Fig. 10, the composite solder ribbon 100 has a first connecting portion 103. An included angle a between the first connecting portion 103 and a backlight surface of the back contact solar cell is greater than or equal to 0° and less than or equal to 60°. The included angle a and the yield strength σs of the composite solder ribbon 100 satisfy the following relationship: $(90/1.63) \times \cos a \leq \sigma s \leq \cos a \times 90$, where a is greater than or equal to 0° and less than or equal to 60°. When the composite solder ribbon 100 is used for serial soldering of the cell pieces, there are different arrangement forms between the cell pieces. The first connecting portion 103 is arranged to achieve high-quality connections between the cell pieces. In some embodiments, the plurality of back contact solar cells are arranged at intervals. In this case, the composite solder ribbon 100 can connect the plurality of back contact solar cells while maintaining a straight morphology. The included angle a between the first connecting portion and the backlight surface of the back contact solar cell is greater than or equal to 0° and less than or equal to 20°. In some implementations, the included angle a between the first connecting portion and the backlight surface of the back contact solar cell is greater than or equal to 0° and less than or equal to 10°. Further, the included angle a between the first connecting portion and the backlight surface of the back contact solar cell is greater than or equal to 0° and less than or equal to 5°. In some embodiments, the plurality of back contact solar cells are partially overlapped. The included angle a between the first connecting portion 103 and the back contact solar cell is greater than or equal to 10° and less than or equal to 60°. In some implementations, the included angle a between the first connecting portion and the backlight surface of the back contact solar cell is greater than or equal to 10° and less than or equal to 45°. Due to a certain thickness of the cell piece, a stepped structure is formed in a partially overlapped area of the back contact solar cells. The composite solder ribbon 100 bends locally when passing through the overlapped area, and a bending portion is the first connecting portion 103. The included angle between the first connecting portion 103 and the backlight surface of the back contact solar cell is determined according to a local degree of bending of the composite solder ribbon 100 and the thickness of the cell piece. Through the special design of the composite solder ribbon 100, the present disclosure further ensures good adhesion and stable welding without deformation between the composite solder ribbon 100 and the cell pieces when using the composite solder ribbon 100 for serial soldering of the cell pieces. Especially in the overlapped area between the cell pieces, the composite solder ribbon 100 can achieve smooth transition connections, avoiding phenomena such as cold soldering or desoldering of the composite solder ribbon 100 in the overlapped area of the cell pieces.

It should be particularly noted that the included angle a between the first connecting portion 103 and the back contact solar cell 200 is an included angle formed between a straight line connecting two points where the first connecting portion 103 makes contact with two adjacent back contact solar cells 200 and a surface of the back contact solar cell 200, as shown in Fig. 10.

The yield strength of the composite solder ribbon 100 may be measured through tensile testing. Specifically, a sample (in this case, the composite solder ribbon 100) is placed in a tensile testing machine, and tensile force is gradually applied while measuring and recording a stress-strain curve. The curve reflects a relationship between the deformation of the sample and the applied stress in a stretching process. Through the curve, the yield strength of the composite solder ribbon 100, which is a stress value at the onset of plastic deformation of the sample, may be determined.

By setting the corresponding yield strengths for the composite solder ribbon 100 based on different sizes and corresponding component ratios, and controlling the yield strength of the composite solder ribbon 100 within a preset range, the present disclosure can solve the problem of cell piece warping caused by easy warping of the composite solder ribbon 100. The morphology, composition, and size of the composite solder ribbon 100 can be diversely designed to meet process requirements of various types of solar cell assembly. Compared to conventional copper solder ribbons, the cost is greatly reduced, thereby effectively reducing the production cost of the cell assembly.

In some embodiments, the composite solder ribbon 100 includes a composite structure layer 104. The first conductive layer 101 and the second conductive layer 102 are compounded to form the composite structure layer 104, which is arranged between the first conductive layer 101 and the second conductive layer 102. The compounding of the first conductive layer 101 and the second conductive layer 102 refers to metallurgically bonding the first conductive layer 101 and the second conductive layer 102 together through methods such as forging or casting. The composite structure layer 104 is an intermetallic compound formed during the metallurgical bonding process of the first conductive layer 101 and the second conductive layer 102. The composite structure layer 104 can achieve tight bonding between the first conductive layer 101 and the second conductive layer 102, allowing for consistent changes when subjected to external stress, without delamination or peeling. Further, a thickness of the composite structure layer 104 is 0 to 30 micrometers. In some implementations, the thickness of the composite structure layer 104 is 15 to 30 micrometers. In such embodiments, the thickness of the composite structure layer 104 may be 15 micrometers, 20 micrometers, 25 micrometers, 30 micrometers, or any value between 15 micrometers and 30 micrometers, with no specific limitations imposed herein. With the thickness of the composite structure layer 104 within this range, high bonding strength and peel strength between the first conductive layer 101 and the second conductive layer 102 can be ensured, thereby preventing peeling or detachment between the two layers due to force.

Further, components of the composite structure layer 104 include at least one of $Al_4Cu_9$, AlCu, $Al_2Cu$, $Al_2Cu_3$, $Al_3Cu_4$, or Cu. The formation of the intermetallic compound is key to achieving effective connections. These compounds can form strong chemical bonds at a connection interface, thereby enhancing the connection strength. By controlling process parameters (e.g., a temperature, a time, and a pressure) during the bonding of the first conductive layer 101 and the second conductive layer 102, the types and quantities of intermetallic compounds can be regulated, thus optimizing the connection performance. Additionally, the foregoing intermetallic compound can further enhance the corrosion resistance of the composite solder ribbon 100.

In some embodiments, the composite solder ribbon 100 further includes a conductive connecting layer 105 arranged on a surface of the second conductive layer 102. Specifically, the conductive connecting layer 105 and the second conductive layer 102 can achieve metallurgical bonding through hot-dip plating. In a hot-press connection process between the composite solder ribbon 100 and the cell pieces, the conductive connecting layer 105 melts and then cools to implement the soldering between the composite solder ribbon 100 and the cell pieces. Further, a thickness of the conductive connecting layer 105 is 1 to 20 micrometers. In some implementations, the thickness of the conductive connecting layer 105 is 10 micrometers to 15 micrometers. In such embodiments, the thickness of the conductive connecting layer 105 may be 10 micrometers, 12 micrometers, 13 micrometers, 15 micrometers, or any value between 10 micrometers and 15 micrometers, with no specific limitations imposed herein.

Further, components of the conductive connecting layer 105 include at least one of Sn, Bi, or Pb. By setting the components of the conductive connecting layer 105, a low-temperature composite solder ribbon 100 or a high-temperature composite solder ribbon 100 may be formed. Specifically, based on a first preset temperature, which is a soldering temperature between the composite solder ribbon 100 and the cell pieces and ranges from 200°C to 300°C, the low-temperature composite solder ribbon 100 may achieve the connection of metal materials at a low temperature, avoiding damage to electronic components or specific materials caused by high temperatures. Specifically, the components of the conductive connecting layer 105 include Sn, Bi, and Pb, where the Bi content is 10% to 40%, the Sn content is 20% to 50%, and the Pb content is 30% to 60%. By controlling content ratios of Sn, Bi, and Pb, a melting point and a thermal expansion coefficient of the conductive connecting layer 105 can be controlled.

Based on a second preset temperature, which is a soldering temperature between the composite solder ribbon 100 and the cell pieces and specifically ranges from 500°C to 600°C, the high-temperature composite solder ribbon 100 can ensure the strength and stability of the soldering. Specifically, the components of the conductive connecting layer 105 include Sn and Pb, where the Sn content is 50% to 70%, and the Pb content is 30% to 50%. By controlling content ratios of Sn and Pb, the melting point and the thermal expansion coefficient of the conductive connecting layer 105 can be controlled.

As shown in Figs. 1 to 6, it should be noted that the conductive connecting layer 105 may be arranged on a single side surface of the composite solder ribbon 100 facing the back contact cell piece, or on two side surfaces of the composite solder ribbon 100, facing towards and away from the back contact cell piece. An arrangement form of the conductive connecting layer 105 and the composite solder ribbon 100 is set according to production process requirements, with no limitations imposed by the present disclosure.

In some embodiments, a resistance of the composite solder ribbon 100 is greater than or equal to 60 milliohms and less than or equal to 150 milliohms. When a resistance value of the composite solder ribbon 100 is within the foregoing range, the series resistance of the module can be significantly reduced, thereby improving the current transmission efficiency. This means that the solar cells can more effectively convert light energy into electrical energy, reducing energy loss during transmission.

In some embodiments, the composite solder ribbon 100 further includes a connecting layer 108 arranged between the first conductive layer 101 and the second conductive layer 102. Exemplarily, in an electroplating process, since copper plating on aluminum is difficult, according to the present disclosure, the connecting layer 108 is arranged between the first conductive layer 101 and the second conductive layer 102 to achieve good bonding between the first conductive layer 101 and the second conductive layer 102. In some implementations, the connecting layer 108 includes zinc. Of course, in other embodiments, the connecting layer 108 may also include other materials, with no limitations imposed by the present disclosure.

In this embodiment of the present disclosure, the composite solder ribbon 100 may have different morphological structures. Based on different morphological structures, the composite solder ribbon 100 has different size characteristics. Exemplarily, the composite solder ribbon 100 is a flat solder ribbon. The preset size includes a width and thickness of the composite solder ribbon 100. Specifically, when the thickness of the composite solder ribbon 100 is 0.1 mm, the width of the composite solder ribbon 100 is less than 2.5 mm; or, when the width of the composite solder ribbon 100 is 2.5 mm, the thickness of the composite solder ribbon 100 is greater than 0.1 mm. Therefore, the structural stability and sufficient structural strength of the flat composite solder ribbon 100 can be ensured, thereby achieving a stable connection between the composite solder ribbon 100 and the cell pieces.

As shown in Figs. 1 to 6, an example of the composite solder ribbon 100 being the flat solder ribbon is as follows:

In some embodiments, when the width of the composite solder ribbon 100 is 0.4 mm to 0.8 mm and the thickness of the composite solder ribbon 100 is 0.2 mm to 0.3 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

In some embodiments, when the width of the composite solder ribbon 100 is 0.8 mm to 1.4 mm and the thickness of the composite solder ribbon 100 is 0.12 mm to 0.2 mm: the composite solder ribbon component ratio C is 0.2 to 0.3, and the yield strength is 55 MPa to 65 MPa; or, the composite solder ribbon component ratio C is 0.3 to 0.8, and the yield strength is 60 MPa to 70 MPa; or, the composite solder ribbon component ratio C is 0.8 to 1.2, and the yield strength is 62 MPa to 72 MPa; or, the composite solder ribbon component ratio C is 1.2 to 2, and the yield strength is 65 MPa to 75 MPa; or, the composite solder ribbon component ratio C is 2 to 3, and the yield strength is 70 MPa to 80 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

In some embodiments, when the width of the composite solder ribbon 100 is 1.4 mm to 1.8 mm and the thickness of the composite solder ribbon 100 is 0.1 mm to 0.15 mm: the composite solder ribbon component ratio C is 0.2 to 0.3, and the yield strength is 55 MPa to 65 MPa; or, the composite solder ribbon component ratio C is 0.3 to 0.8, and the yield strength is 60 MPa to 70 MPa; or, the composite solder ribbon component ratio C is 0.8 to 1.2, and the yield strength is 62 MPa to 72 MPa; or, the composite solder ribbon component ratio C is 1.2 to 2, and the yield strength is 65 MPa to 75 MPa; or, the composite solder ribbon component ratio C is 2 to 3, and the yield strength is 70 MPa to 80 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

In some embodiments, when the width of the composite solder ribbon 100 is 1.8 mm to 2.2 mm and the thickness of the composite solder ribbon 100 is 0.12 mm to 0.2 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

In some embodiments, when the width of the composite solder ribbon 100 is 1.8 mm to 2.2 mm and the thickness of the composite solder ribbon 100 is 0.05 mm to 0.12 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

In some embodiments, when the width of the composite solder ribbon 100 is 2.2 mm to 2.8 mm and the thickness of the composite solder ribbon 100 is 0.12 mm to 0.2 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

As shown in Fig. 7, in some embodiments, the composite solder ribbon 100 is a round wire solder ribbon, with a diameter length greater than or equal to 0.07 mm and less than or equal to 0.4 mm. Within the diameter range, the composite solder ribbon 100 can provide a sufficient soldering area to ensure the strength and stability of the soldering.

An example of the composite solder ribbon 100 being the round wire solder ribbon is as follows:

In some embodiments, when the diameter length of the composite solder ribbon 100 is 0.07 mm to 0.2 mm: the composite solder ribbon component ratio C is 0.2 to 0.3, and the yield strength is 65 MPa to 75 MPa; or, the composite solder ribbon component ratio C is 0.3 to 0.8, and the yield strength is 70 MPa to 80 MPa; or, the composite solder ribbon component ratio C is 0.8 to 1.2, and the yield strength is 72 MPa to 82 MPa; or, the composite solder ribbon component ratio C is 1.2 to 2, and the yield strength is 75 MPa to 85 MPa; or, the composite solder ribbon component ratio C is 2 to 3, and the yield strength is 80 MPa to 90 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

In some embodiments, when the diameter length of the composite solder ribbon 100 is 0.2 mm to 0.3 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

In some embodiments, when the diameter length of the composite solder ribbon 100 is 0.3 mm to 0.4 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa. The setting of the component ratio may be selected according to a production process and the type of cell pieces. Therefore, based on the same size and morphology, the composite solder ribbon 100 is set with corresponding yield strengths according to the foregoing different component ratios, thereby adaptively adjusting the mechanical performance of the composite solder ribbon 100. By controlling the yield strength of the composite solder ribbon 100 within the preset range, the problem of the easy cell piece warping caused by deformation of the composite solder ribbon 100 can be solved.

As shown in Fig. 8, in some embodiments, the composite solder ribbon 100 is a triangular solder ribbon, with a diameter length of a circumscribed circle of the composite solder ribbon 100 being greater than or equal to 0.07 mm and less than or equal to 0.4 mm. Within the size range, the composite solder ribbon 100 can provide a sufficient soldering area to ensure the strength and stability of the soldering.

In some embodiments, a ratio of a thickness of the first conductive layer 101 to a thickness of the second conductive layer 102 is greater than or equal to 5 and less than or equal to 9. Exemplarily, the ratio of the thickness of the first conductive layer 101 to the thickness of the second conductive layer 102 may be 5, 6, 7, 8, 9, or any value between 5 and 9, with no specific limitations imposed herein. Within the ratio range, when subjected to external forces or environmental factors (e.g., changes in temperature and humidity), the thick first conductive layer 101 can better resist deformation, thereby maintaining the integrity and performance of the first conductive layer 101. Although the second conductive layer 102 is thin, the composite solder ribbon 100 formed by combining the second conductive layer 102 with the thick first conductive layer 101 can avoid warping, forming a more continuous and stable conductive path, thereby improving conductive efficiency. In some implementations, the thickness of the second conductive layer 102 is 0.01 mm to 0.05 mm. Exemplarily, the thickness may be 0.01 mm, 0.02 mm, 0.03 mm, 0.04 mm, 0.05 mm, or any value between 0.01 mm and 0.05 mm, with no specific limitations imposed herein.

The thickness of the first conductive layer 101 and the second conductive layer 102 mentioned in the present disclosure refers to an average thickness of films of the first conductive layer 101 and the second conductive layer 102.

As shown in Fig. 3, in some embodiments, the first conductive layer 101 has a first surface and a second surface opposite to each other in a thickness direction, and both the first surface and the second surface are provided with the second conductive layer 102. The second conductive layer 102 covering the first surface has a first thickness, while the second conductive layer 102 covering the second surface has a second thickness. The first surface is arranged towards the cell piece, and the second surface is arranged away from the cell piece. In some embodiments, the second thickness is greater than the first thickness. Through the structural design, a connection state between the composite solder ribbon and the cell pieces can be more stable, thereby reducing deformation caused by changes in the external environmental temperature.

The structures of the composite solder ribbon in Figs. 1 to 8 of the present disclosure represent only several typical embodiments designed in the present disclosure, and the structures of the composite solder ribbon in the present disclosure are not only limited to these embodiments.

As shown in Fig. 9, the composite solder ribbon 100 includes a plurality of free portions 106 and a plurality of second connecting portions 107 connecting the plurality of free portions 106. The second connecting portions 107 are connected to the solar cells, while the free portions 106 are detached from the solar cells. Further, in some embodiments of the present disclosure, the free portions 106 are of deformation buffer structures. The connection between the composite solder ribbon 100 and the back contact solar cells 200 is achieved through the second connecting portions 107. During specific fabrication, each second connecting portion 107 of the composite solder ribbon 100 is spot-welded to each solder joint on a busbar of the back contact solar cells 200, while the free portions 106 are detached from the back contact solar cells 200, forming the deformation buffer structures. The deformation buffer structure may be in various bending shapes, such as an arc, an S shape, a rectangle, or a zigzag shape. It should be noted that all the second connecting portions 107 are in the same horizontal plane, so as to make contact with the solder joints of the back contact solar cells 200, while the free portions 106 are bent and deformed to be in a different horizontal plane from the second connecting portions 107, extending from the second connecting portions 107. Further, a maximum spacing distance between the free portions 106 and the solar cells ranges from 0.1 mm to 0.4 mm. When the composite solder ribbon 100 is bent to form the free portions 106, the composite solder ribbon 100 has sufficient buffer allowance compared to an existing flat state to accommodate the contraction or expansion of the composite solder ribbon 100.

Therefore, after the second connecting portions 107 of the composite solder ribbon 100 are welded to the solder joints of the back contact solar cells 200, the free portions 106 may provide a certain amount of buffering between two adjacent solder joints, thereby allowing for buffering and compensating for the deformation caused by the contraction of the composite solder ribbon 100 after returning to a room temperature due to differences in thermal expansion coefficients between the composite solder ribbon 100 and the back contact solar cells 200, reducing stress caused by thermal expansion and contraction, reducing the problem about warping of the back contact solar cells 200 caused by welding, and thus resulting in flatter welded back contact solar cells 200 compared to existing solar cells. Meanwhile, the contracting composite solder ribbon 100 may also reduce a protruding height of the free portions 106, resulting in a flatter composite solder ribbon 100 that undergoes deformation compensation after welding, thereby achieving low warping for the entire module of the back-contact solar cells 200.

In some embodiments, the plurality of back contact solar cells 200 are partially overlapped to form an overlapped area, with the first connecting portions 103 of the composite solder ribbon 100 arranged in the overlapped area, thereby ensuring good adhesion and stable welding without deformation between the composite solder ribbon 100 and the cell pieces when using the composite solder ribbon 100 for serial soldering of the cell pieces. Especially in the overlapped area between the cell pieces, the composite solder ribbon 100 can achieve smooth transition connections, avoiding phenomena such as cold soldering or desoldering of the composite solder ribbon 100 in the overlapped area of the cell pieces.

A photovoltaic system includes the foregoing solar cell assembly. In this embodiment, the photovoltaic system may be applied to a photovoltaic power station, such as a ground-mounted power station, a rooftop power station, and a water surface power station, or may also be applied to a device or apparatus that generates electricity using solar energy, such as a user solar power supply, a solar streetlamp, a solar car, and a solar building. Certainly, it should be understood that application scenarios of the photovoltaic system are not limited to these. That is, the photovoltaic system may be applied to all fields where the solar energy needs to be used for power generation. Taking a photovoltaic power generation system as an example, the photovoltaic system may include a photovoltaic array, a combiner box, and an inverter. The photovoltaic array may be an array combination of a plurality of cell assembly. For example, the plurality of cell assembly may form a plurality of photovoltaic arrays, which are connected to the combiner box. The combiner box may converge currents generated by the photovoltaic arrays, and the converged current flows through the inverter to be converted into alternating current power required by a utility grid, and then is connected to a utility network to achieve solar power supply.

In the descriptions of this specification, descriptions using reference terms such as "some embodiments", "an exemplary embodiment", "an example", "a specific example", or "some examples" mean that specific features, structures, materials, or characteristics described with reference to the embodiment or the example are included in at least some embodiments or examples of the present disclosure. In this specification, the schematic representations of the foregoing terms are not necessarily intended to refer to the same embodiment or example. Moreover, the described specific features, structures, materials, or characteristics may be combined in a suitable manner in any one or more of the embodiments or examples.

The foregoing descriptions are merely preferred embodiments of the present disclosure, but are not intended to limit the present disclosure. Any modification, equivalent substitution, improvement, etc. made within the spirit and principle of the present disclosure shall fall within the scope of protection of the present disclosure.

## Claims

1. A back contact solar cell assembly, comprising composite solder ribbons and a plurality of back contact solar cells, wherein the composite solder ribbons are arranged on backlight surfaces of the plurality of back contact solar cells, each of the composite solder ribbons comprises a first conductive layer and a second conductive layer, the second conductive layer is arranged on an outer surface of the first conductive layer, the first conductive layer comprises an aluminum element, and the second conductive layer comprises a copper element or a nickel element; a mass ratio of the second conductive layer to the first conductive layer of each of the composite solder ribbons is a composite solder ribbon component ratio C which is greater than or equal to 0.1, each of the composite solder ribbons has a first connecting portion which is arranged between the two adjacent back contact solar cells, an included angle a between the first connecting portion and the backlight surface of the back contact solar cell is greater than $0°$ and less than or equal to $60°$, the included angle a is an included angle formed between a straight line connecting two points where the first connecting portion makes contact with two adjacent back contact solar cells and a surface of the back contact solar cell, and the included angle a and a yield strength $\sigma s$ of the composite solder ribbons satisfy the following relationship:

$$(90/1.63) \times \cos a \leq \sigma s \leq \cos a \times 90,$$

   wherein a is greater than $0°$ and less than or equal to $60°$.

2. The back contact solar cell assembly according to claim 1, wherein the plurality of back contact solar cells are arranged at intervals, and the included angle a between the first connecting portion and the back contact solar cell is greater than $0°$ and less than or equal to $20°$.

3. The back contact solar cell assembly according to claim 2, wherein the included angle a between the first connecting portion and the backlight surface of the back contact solar cell is greater than $0°$ and less than or equal to $10°$.

4. The back contact solar cell assembly according to claim 3, wherein the included angle a between the first connecting portion and the backlight surface of the back contact solar cell is greater than 0° and less than or equal to 5°.

5. The back contact solar cell assembly according to claim 1, wherein the plurality of back contact solar cells are partially overlapped, and the included angle a between the first connecting portion and the backlight surface of the back contact solar cell is greater than or equal to 10° and less than or equal to 60°.

6. The back contact solar cell assembly according to claim 5, wherein the included angle a between the first connecting portion and the backlight surface of the back contact solar cell is greater than or equal to 10° and less than or equal to 45°.

7. The back contact solar cell assembly according to claim 1, wherein the composite solder ribbon component ratio C is greater than or equal to 0.2.

8. The back contact solar cell assembly according to claim 1, wherein the composite solder ribbon component ratio C ranges from 0.25 to 2.4.

9. The back contact solar cell assembly according to claim 1, wherein each of the composite solder ribbons further comprise a composite structure layer, and the first conductive layer and the second conductive layer are compounded to form the composite structure layer, which is arranged between the first conductive layer and the second conductive layer.

10. The back contact solar cell assembly according to claim 9, wherein a thickness of the composite structure layer is 0 to 30 micrometers.

11. The back contact solar cell assembly according to claim 9, wherein components of the composite structure layer comprise at least one of $Al_4Cu_9$, AlCu, $Al_2Cu$, $Al_2Cu_3$, $Al_3Cu_4$, or Cu.

12. The back contact solar cell assembly according to claim 1, wherein each of the composite solder ribbons further comprise a conductive connecting layer arranged on a surface of the second conductive layer.

13. The back contact solar cell assembly according to claim 12, wherein a thickness of the conductive connecting layer is 1 to 20 micrometers.

14. The back contact solar cell assembly according to claim 12, wherein components of the conductive connecting layer comprise at least one of Sn, Bi, or Pb.

15. The back contact solar cell assembly according to claim 14, wherein based on a first preset temperature, the components of the conductive connecting layer comprise Sn, Bi, and Pb, the Bi content is 10% to 40%, the Sn content is 20% to 50%, and the Pb content is 30% to 60%.

16. The back contact solar cell assembly according to claim 14, wherein based on a second preset temperature, the components of the conductive connecting layer comprise Sn and Pb, the Sn content is 50% to 70%, and the Pb content is 30% to 50%.

17. The back contact solar cell assembly according to claim 1, wherein a resistance of the composite solder ribbon is greater than or equal to 60 milliohms and less than or equal to 150 milliohms.

18. The back contact solar cell assembly according to claim 1, further comprising a connecting layer, which is arranged between the first conductive layer and the second conductive layer.

19. The back contact solar cell assembly according to claim 18, wherein the connecting layer comprises zinc.

20. The back contact solar cell assembly according to claim 1, wherein the composite solder ribbon is a flat solder ribbon.

21. The back contact solar cell assembly according to claim 20, wherein when a thickness of the composite solder ribbon is 0.1 mm, a width of the composite solder ribbon is less than 2.5 mm; or, when a width of the composite solder ribbon is 2.5 mm, a thickness of the composite solder ribbon is greater than 0.1 mm.

22. The back contact solar cell assembly according to claim 20, wherein when a width of the composite solder ribbon is 0.4 mm to 0.8 mm and a thickness of the composite solder ribbon is 0.2 mm to 0.3 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa.

23. The back contact solar cell assembly according to claim 20, wherein when a width of the composite solder ribbon is 0.8 mm to 1.4 mm and a thickness of the composite solder ribbon is 0.12 mm to 0.2 mm: the composite solder ribbon component ratio C is 0.2 to 0.3, and the yield strength is 55 MPa to 65 MPa; or, the composite solder ribbon component ratio C is 0.3 to 0.8, and the yield strength is 60 MPa to 70 MPa; or, the composite solder ribbon component ratio C is 0.8 to 1.2, and the yield strength is 62 MPa to 72 MPa; or, the composite solder ribbon component ratio C is 1.2 to 2, and the yield strength is 65 MPa to 75 MPa; or, the composite solder ribbon component ratio C is 2 to 3, and the yield strength is 70 MPa to 80 MPa.

24. The back contact solar cell assembly according to claim 20, wherein when a width of the composite solder ribbon is 1.4 mm to 1.8 mm and a thickness of the composite solder ribbon is 0.1 mm to 0.15 mm: the composite solder ribbon component ratio C is 0.2 to 0.3, and the yield strength is 55 MPa to 65 MPa; or, the composite solder ribbon component ratio C is 0.3 to 0.8, and the yield strength is 60 MPa to 70 MPa; or, the composite solder ribbon component ratio C is 0.8 to 1.2, and the yield strength is 62 MPa to 72 MPa; or, the composite solder ribbon component ratio C is 1.2 to 2, and the yield strength is 65 MPa to 75 MPa; or, the composite solder ribbon component ratio C is 2 to 3, and the yield strength is 70 MPa to 80 MPa.

25. The back contact solar cell assembly according to claim 20, wherein when a width of the composite solder ribbon is 1.8 mm to 2.2 mm and a thickness of the composite solder ribbon is 0.12 mm to 0.2 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa.

26. The back contact solar cell assembly according to claim 20, wherein when a width of the composite solder ribbon is 1.8 mm to 2.2 mm and a thickness of the composite solder ribbon is 0.05 mm to 0.12 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa.

27. The back contact solar cell assembly according to claim 20, wherein when a width of the composite solder ribbon is 2.2 mm to 2.8 mm and a thickness of the composite solder ribbon is 0.12 mm to 0.2 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 60 MPa to 70 MPa; or, the composite solder ribbon component ratio C is 1.2 to 2, and the yield strength is 62 MPa to 72 MPa; or, the composite solder ribbon component ratio C is 2 to 3, and the yield strength is 65 MPa to 75 MPa.

28. The back contact solar cell assembly according to claim 1, wherein the composite solder ribbon is a round wire solder ribbon, with a diameter length greater than or equal to 0.07 mm and less than or equal to 0.4 mm.

29. The back contact solar cell assembly according to claim 28, wherein when the diameter length of the composite solder ribbon is 0.07 mm to 0.2 mm: the composite solder ribbon component ratio C is 0.2 to 0.3, and the yield strength is 65 MPa to 75 MPa; or, the composite solder ribbon component ratio C is 0.3 to 0.8, and the yield strength is 70 MPa to 80 MPa; or, the composite solder ribbon component ratio C is 0.8 to 1.2, and the yield strength is 72 MPa to 82 MPa; or, the composite solder ribbon component ratio C is 1.2 to 2, and the yield strength is 75 MPa to 85 MPa; or, the composite solder ribbon component ratio C is 2 to 3, and the yield strength is 80 MPa to 90 MPa.

30. The back contact solar cell assembly according to claim 28, wherein when the diameter length of the composite solder ribbon is 0.2 mm to 0.3 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa.

31. The back contact solar cell assembly according to claim 28, wherein when the diameter length of the composite solder ribbon is 0.3 mm to 0.4 mm: the composite solder ribbon component ratio C is 0.2 to 0.3, and the yield strength is 50 MPa to 60 MPa; or, the composite solder ribbon component ratio C is 0.3 to 0.8, and the yield strength is 55 MPa to 65 MPa; or, the composite solder ribbon component ratio C is 0.8 to 1.2, and the yield strength is 58 MPa to 68 MPa; or, the composite solder ribbon component ratio C is 1.2 to 2, and the yield strength is 60 MPa to 70 MPa; or, the composite solder ribbon component ratio C is 2 to 3, and the yield strength is 65 MPa to 75 MPa.

**32.** The back contact solar cell assembly according to claim 1, wherein the composite solder ribbon is a triangular solder ribbon, with a diameter length of a circumscribed circle of the composite solder ribbon being greater than or equal to 0.07 mm and less than or equal to 0.4 mm.

**33.** The back contact solar cell assembly according to claim 1, wherein a ratio of a thickness of the first conductive layer to a thickness of the second conductive layer is greater than or equal to 5 and less than or equal to 9.

**34.** The back contact solar cell assembly according to claim 1, wherein a thickness of the second conductive layer is 0.01 mm to 0.05 mm.

**35.** The back contact solar cell assembly according to claim 1, wherein each of the composite solder ribbons comprise a plurality of free portions and a plurality of second connecting portions connecting the plurality of free portions, and the second connecting portions are connected to the back contact solar cells, while the free portions are detached from the back contact solar cells.

**36.** The back contact solar cell assembly according to claim 35, wherein a maximum spacing distance between the free portions and the back contact solar cells ranges from 0.1 mm to 0.4 mm.

**37.** A photovoltaic system, comprising the back contact solar cell assembly according to any one of claims 1 to 36.

Fig. 1

Fig. 2

Fig. 3

104
105

105
101
102

Fig. 4

108
105

105
101
102

Fig. 5

104
104
105

105
102
101
102

Fig. 6

Fig. 7

Fig. 8

Fig. 9

Fig. 10

**TRANSLATION**

<div align="center">

### INTERNATIONAL SEARCH REPORT

</div>

| International application No. |
|---|
| **PCT/CN2025/099376** |

| A. | CLASSIFICATION OF SUBJECT MATTER |
|---|---|

H10F19/90(2025.01)i

According to International Patent Classification (IPC) or to both national classification and IPC

| B. | FIELDS SEARCHED |
|---|---|

Minimum documentation searched (classification system followed by classification symbols)

IPC: H10F, H01L

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 太阳能电池, 光伏, 背接触, 焊带, 屈服强度, solar cell, photovoltaic, back contact, weld strip, yield strength

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 119317197 A (ZHEJIANG AIKO SOLAR ENERGY TECHNOLOGY CO., LTD.) 14 January 2025 (2025-01-14)<br>    description, paragraphs [0005]-[0088], and figures 1-10 | 1-37 |
| Y | CN 118841468 A (ZHUHAI FUSHAN AIKO SOLAR ENERGY TECHNOLOGY CO., LTD. et al.) 25 October 2024 (2024-10-25)<br>    description, paragraphs [0003]-[0116], and figures 1-10 | 1-37 |
| Y | CN 1957479 A (NEOMAX MATERIALS CO., LTD.) 02 May 2007 (2007-05-02)<br>    description, page 2, paragraph 8 to page 11, paragraph 2, and figures 2-5 | 1-37 |
| A | CN 114628542 A (ZHEJIANG AIKO SOLAR ENERGY TECHNOLOGY CO., LTD. et al.) 14 June 2022 (2022-06-14)<br>    entire document | 1-37 |
| A | US 2023275172 A1 (LONGI SOLAR TECHNOLOGY (TAIZHOU) CO., LTD.) 31 August 2023 (2023-08-31)<br>    entire document | 1-37 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **28 August 2025** | **03 September 2025** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2025/099376**

| Patent document cited in search report | | | Publication date (day/month/year) | Patent family member(s) | | | Publication date (day/month/year) |
|---|---|---|---|---|---|---|---|
| CN | 119317197 | A | 14 January 2025 | None | | | |
| CN | 118841468 | A | 25 October 2024 | CN | 223053370 | U | 01 July 2025 |
| CN | 1957479 | A | 02 May 2007 | EP | 1758175 | A1 | 28 February 2007 |
| | | | | EP | 1758175 | A4 | 28 July 2010 |
| | | | | EP | 1758175 | B1 | 04 May 2016 |
| | | | | EP | 1758175 | B2 | 29 May 2019 |
| | | | | JP | 2011258963 | A | 22 December 2011 |
| | | | | JP | 5616853 | B2 | 29 October 2014 |
| | | | | ES | 2581783 | T3 | 07 September 2016 |
| | | | | ES | 2581783 | T5 | 28 October 2019 |
| | | | | JP | 2015015482 | A | 22 January 2015 |
| | | | | JP | 5765471 | B2 | 19 August 2015 |
| | | | | KR | 20120120977 | A | 02 November 2012 |
| | | | | KR | 101341232 | B1 | 12 December 2013 |
| | | | | US | 2008169020 | A1 | 17 July 2008 |
| | | | | US | 7754973 | B2 | 13 July 2010 |
| | | | | JP | 4986615 | B2 | 25 July 2012 |
| | | | | WO | 2005114751 | A1 | 01 December 2005 |
| | | | | EP | 3012872 | A2 | 27 April 2016 |
| | | | | EP | 3012872 | A3 | 17 August 2016 |
| | | | | EP | 3012872 | B1 | 12 July 2017 |
| | | | | KR | 20070033335 | A | 26 March 2007 |
| | | | | KR | 20130007653 | A | 18 January 2013 |
| | | | | KR | 101245042 | B1 | 18 March 2013 |
| | | | | JP | 2015029108 | A | 12 February 2015 |
| | | | | JP | 5692450 | B2 | 01 April 2015 |
| | | | | CN | 100521248 | C | 29 July 2009 |
| CN | 114628542 | A | 14 June 2022 | CN | 216958062 | U | 12 July 2022 |
| US | 2023275172 | A1 | 31 August 2023 | WO | 2022041515 | A1 | 03 March 2022 |
| | | | | EP | 4207316 | A1 | 05 July 2023 |
| | | | | EP | 4207316 | A4 | 16 October 2024 |
| | | | | JP | 2023539887 | A | 20 September 2023 |
| | | | | JP | 7595750 | B2 | 06 December 2024 |
| | | | | AU | 2020465021 | A1 | 23 March 2023 |
| | | | | AU | 2020465021 | B2 | 05 December 2024 |
| | | | | US | 12224366 | B2 | 11 February 2025 |
| | | | | CN | 112071933 | A | 11 December 2020 |

Form PCT/ISA/210 (patent family annex) (July 2022)

**EP 4 788 091 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411823605